# EUROPEAN PATENT APPLICATION

(11) **EP 4 686 327 A1**
(43) Date of publication of application: **28.01.2026**
(21) Application number: 23929812.8
(22) Date of filing: 05.09.2023
(51) Int. Cl.: H05K 7/20

(54) **TWO-PHASE LIQUID COOLING SYSTEM**

(30) Priority: 24.03.2023 CN 202310302110
(71) Applicant: xFusion Digital Technologies Co., Ltd., Henan 450000 (CN)
(72) Inventor: DING, Junfeng, Zhengzhou, Henan 450000 (CN)
(74) Representative: Isarpatent
(86) International application number: PCT/CN2023/117101
(87) International publication number: WO 2024/198238

(57) **Abstract**

The present application discloses a two-phase liquid-cooling system. The system includes at least one liquid-cooling node, a first chamber, and a condenser. The liquid-cooling node is configured to accommodate a heat source component and an insulating working medium; the condenser is configured to liquefy a gaseous insulating working medium into a liquid insulating working medium; a first inlet of the first chamber is connected to a flow channel outlet of each liquid-cooling node, and a gas outlet of the first chamber is connected to a first inlet of the condenser, and a first outlet of the condenser and a liquid outlet of the first chamber are respectively connected to a flow channel inlet of each liquid-cooling node. The first chamber is disposed between the liquid-cooling node and the condenser for gas-liquid separation, which not only may save economic and energy costs required for deployment and operation of a gas-liquid separator, but also may avoid that the flow channel outlet is blocked since the liquid insulating working medium directly flows back to the liquid-cooling node, solving a layout limitation problem of the flow channel outlet on the liquid-cooling node, thereby making the layout of the liquid-cooling node more flexible.

## Description

This application claims priority to Chinese Patent Application No. 202310302110.2 filed with the China National Intellectual Property Administration on March 24, 2023, entitled "TWO-PHASE LIQUID-COOLING SYSTEM", which is incorporated herein by reference in its entirety.

### TECHNICAL FIELD

The present application relates to the field of heat dissipation technologies, and in particular to a two-phase liquid-cooling system.

### BACKGROUND

As data centers develop toward a high power density, conventional air cooling methods cannot meet heat dissipation requirements of the data centers. At present, there have been designs that adopt a liquid cooling means for dissipating heat from the data centers. In a liquid-cooling system, an immersion liquid cooling solution has a significant advantage in energy efficiency since a non-conductive cooling working medium can directly contact the server and take away 100% heat of the server.

There are mainly two existing immersion liquid cooling forms. One is to place the server in a large tank filled with an insulating working medium. The insulating working medium flows in the large tank without undergoing a phase transition, and solely generates convective heat transfer and heat conduction with the server. However, this form has a large demand for the insulating working medium, resulting in a high cost.

The other one is to place the server in a liquid-cooling node filled with an insulating working medium. The insulating working medium absorbs heat generated by the server and undergoes a phase transition into a gaseous insulating working medium. The gaseous insulating working medium is conveyed to a condenser through a gas outlet of the liquid-cooling node, and reverts to its liquid state after releasing heat. Then, the liquid insulating working medium may be directly returned to the liquid-cooling node.

However, the above two-phase liquid-cooling system requires the gas outlet of the liquid-cooling node to be higher than the condenser to avoid backflow of the condensed liquid causing the gas outlet of the liquid-cooling node to be blocked and affecting the circulation of the insulating working medium. This avoids an excessive pressure in the liquid-cooling node, which could exceed its maximum allowable pressure and pose a safety risk. When the liquid-cooling node is disposed at a horizontal slot, an overall height is relatively lower than that of a vertical slot, resulting in a lower height of the gas outlet. The height requirements for the gas outlet of the liquid-cooling node in the two-phase liquid-cooling system result in difficulties in disposing the liquid-cooling node at the horizontal slot, which limits the layout of the liquid-cooling node.

### SUMMARY

Embodiments of the present application provide a two-phase liquid-cooling system, to solve a layout limitation problem of a liquid-cooling node in an existing two-phase liquid-cooling system.

In a first aspect, the embodiments of the present application provide a two-phase liquid-cooling system. The system includes:
at least one liquid-cooling node, where the liquid-cooling node is configured to accommodate a heat source component and an insulating working medium, and the insulating working medium is capable of absorbing heat from the heat source component to be transitioned from a liquid state to a gaseous state; the liquid-cooling node includes a flow channel inlet and a flow channel outlet; a first chamber, where the first chamber includes a first inlet, a gas outlet, and a liquid outlet; and a condenser, where the condenser is configured to liquefy the gaseous insulating working medium into the liquid insulating working medium; and the condenser includes a first inlet and a first outlet;
the first inlet of the first chamber is connected to the flow channel outlet of each liquid-cooling node, the gas outlet of the first chamber is connected to the first inlet of the condenser, and the first outlet of the condenser and the liquid outlet of the first chamber are respectively connected to the flow channel inlet of each liquid-cooling node; and
the insulating working medium accommodated in the liquid-cooling node, after absorbing the heat from the heat source component, is capable of entering the first chamber through the flow channel outlet of the liquid-cooling node and the first inlet of the first chamber; the gaseous insulating working medium in the first chamber is capable of entering the condenser through the gas outlet of the first chamber and the first inlet of the condenser, and after being liquefied by the condenser, entering the liquid-cooling node through the first outlet of the condenser and the flow channel inlet of the liquid-cooling node; and the liquid insulating working medium in the first chamber is capable of entering the liquid-cooling node through the liquid outlet of the first chamber and the flow channel inlet of the liquid-cooling node.

In the embodiments of the present application, the first chamber is disposed between the liquid-cooling node and the condenser for gas-liquid separation, which not only may save economic and energy costs required for deployment and operation of a gas-liquid separator, but also may avoid that the flow channel outlet is blocked since the liquid insulating working medium directly flows back to the liquid-cooling node, solving the layout limitation problem of the flow channel outlet on the liquid-cooling node, thereby making the layout of the liquid-cooling node more flexible.

In a possible implementation, the first chamber further includes a second inlet, the second inlet of the first chamber is lower than the first inlet of the first chamber, and the second inlet of the first chamber is connected to the flow channel outlet of each liquid-cooling node.

In the present application, the gaseous insulating working medium discharged from the liquid-cooling node may enter the first chamber through the first inlet under the action of buoyancy, and the liquid insulating working medium discharged may flow into the first chamber through the second inlet under the action of gravity. By disposing the second inlet 22 lower than the first inlet 21, gas-liquid separation may be achieved on the insulating working medium discharged from the liquid-cooling node.

In a possible implementation, the flow channel outlet of each liquid-cooling node is higher than the second inlet of the first chamber.

In the present application, the flow channel outlet of each liquid-cooling node is disposed to be higher than the second inlet of the first chamber, so that the liquid-cooling node can still discharge the liquid insulating working medium to the first chamber when a liquid level of the first chamber is higher than the second inlet and lower than the flow channel outlet, further avoiding that the flow channel outlet is blocked.

In a possible implementation, the system further includes a control unit, a first pump body, and a liquid level sensor disposed in the first chamber, a first end of the first pump body is connected to the liquid outlet of the first chamber, and a second end of the first pump body is connected to the flow channel inlet of each liquid-cooling node, respectively; and the control unit is configured to control on/off of the first pump body based on liquid level data in the first chamber collected by the liquid level sensor, and the first pump body is configured to pump the liquid insulating working medium in the first chamber to the flow channel inlet of each liquid-cooling node.

In the embodiments of the present application, in a case that the liquid level data reflects that the current second inlet or the flow channel outlet is liquid-sealed, the control unit switches on the first pump body to quickly pump the liquid insulating working medium in the first chamber back to the liquid-cooling node, so as to rapidly reduce the liquid level, which may avoid an excessive pressure in the liquid-cooling node caused by a liquid sealing phenomenon, thereby enhancing reliability of the liquid-cooling system.

In a possible implementation, the system further includes a control unit and a first pressure sensor, the first pressure sensor is disposed in the first chamber; the condenser includes a first proportional valve, a first heat exchange unit, and a first cold source, the first cold source is connected to the first heat exchange unit, the first coolant input from the first cold source exchanges heat with the insulating working medium input from the first chamber in the first heat exchange unit, and the first proportional valve is configured to control a flow rate of the first coolant in the first heat exchange unit; the first pressure sensor is configured to collect first pressure data in the first chamber; and the control unit is configured to control an opening degree of the first proportional valve based on the first pressure data.

In the embodiments of the present application, in a case that the first pressure data reflects that the current air pressure in the first chamber is abnormal, the control unit adjusts a liquefaction rate of the insulating working medium in the condenser, the second chamber, and the first chamber by adjusting the opening degree of the first proportional valve, so that the insulating working medium expands or contracts, thereby achieving the purpose of restoring the air pressure.

In a possible implementation, the system further includes a subcooler, a first inlet of the subcooler is connected to the first outlet of the condenser, and a first outlet of the subcooler is connected to the flow channel inlet of the liquid-cooling node; and the subcooler is configured to reduce temperature of the insulating working medium input to the liquid-cooling node.

In the embodiments of the present application, by configuring the condenser and the subcooler in the liquid-cooling system to take on responsibilities of condensation and cooling respectively, a vaporized insulating working medium in the mixed gas may be first recovered through the condenser, while air in the mixed gas may be separated. Then, an insulating working medium with higher purity is cooled by the subcooler, which can maximize a heat absorption capacity of the insulating working medium while reducing moisture or other conductive components from the air mixed therein, maintaining purity of the insulating working medium, thereby improving safety and heat dissipation efficiency of the liquid-cooling system.

In a possible implementation, the system further includes a second pump body, a first end of the second pump body is connected to the first outlet of the subcooler, and a second end of the second pump body is connected to the flow channel inlet of the liquid-cooling node; and the second pump body is configured to pump the insulating working medium in the subcooler to the liquid-cooling node.

In the embodiments of the present application, by configuration of the second pump body, the liquid insulating working medium may be rapidly replenished for the liquid-cooling node.

In a possible implementation, the system further includes a control unit, a temperature sensor, and a third pressure sensor, the temperature sensor is disposed at the second end of the second pump body, and the third pressure sensor is disposed at the first end of the second pump body; the subcooler includes a second proportional valve, a second heat exchange unit, and a second cold source, the second cold source is connected to the second heat exchange unit, the second coolant input from the second cold source exchanges heat with the insulating working medium received from the subcooler in the second heat exchange unit, and the second proportional valve is configured to control a flow rate of the second coolant in the second heat exchange unit; and the control unit is configured to control an opening degree of the second proportional valve based on temperature data collected by the temperature sensor and third pressure data collected by the third pressure sensor.

In the embodiments of the present application, by configuring the second proportional valve to adjust a cooling capacity input of the second cold source, temperature of the insulating working medium input into the liquid-cooling node may be timely adjusted, and a heat dissipation effect of the liquid-cooling system may be ensured while the utilization efficiency of the second cold source is maximized.

In a possible implementation, the system further includes a liquid reservoir, a first end of the liquid reservoir is connected to the first outlet of the subcooler, and a second end of the liquid reservoir is connected to a first end of the second pump body; the liquid reservoir is configured to store the liquid insulating working medium, and the second pump body is configured to pump the insulating working medium in the liquid reservoir to the liquid-cooling node.

In the embodiments of the present application, by configuration that the liquid reservoir collects the liquid insulating working medium cooled by the subcooler and then conveys the cooled liquid insulating working medium to the liquid-cooling node through the pump body, on one hand, a total amount of the insulating working medium in the liquid-cooling system can be increased, and one the other hand, temperature of an input fluid of the second pump body can be more balanced and an inlet pressure can be more stable.

In a possible implementation, the system includes a control unit, a second pressure sensor, and a bypass valve, a first end of the bypass valve is connected to a second end of the second pump body, and a second end of the bypass valve is connected to the first end of the liquid reservoir; the second pressure sensor is disposed at the second end of the second pump body, and the second pressure sensor is configured to collect second pressure data of an output fluid of the second pump body; and the control unit is configured to control an opening degree of the bypass valve based on the second pressure data.

In the embodiments of the present application, by configuring the bypass valve, overflow of the liquid insulating working medium in the liquid-cooling node 10 due to an excessively fast replenishment speed and affecting the heat dissipation effect can be prevented.

In a possible implementation, the system further includes a second chamber, a flow channel inlet of the second chamber is connected to the first outlet of the condenser, a liquid outlet of the second chamber is connected to a flow channel inlet of the liquid-cooling node, and a gas outlet of the second chamber is connected to outside air.

In the embodiments of the present application, the second chamber is configured to perform another gas-liquid separation on the fluid output from the condenser, which may reduce air content of the liquid insulating working medium in the liquid-cooling system; a discharge port of the liquid-cooling system disposed in the second chamber, compared with a solution that the discharge port is directly disposed in a chamber where mixed gas of the air and the gaseous insulating working medium is located, reduces content of the insulating working medium in the gas discharged from the liquid-cooling system, thereby reducing environmental pollution caused by the insulating working medium and protecting environment.

In a possible implementation, the system further includes a control unit, a solenoid valve, a vacuum pump, and a first pressure sensor; the gas outlet of the second chamber is connected to the outside air through the solenoid valve and the vacuum pump, and the first pressure sensor is disposed in the first chamber; the control unit is configured to control an opening degree of the solenoid valve and on/off of the vacuum pump based on first pressure data in the first chamber collected by the first pressure sensor; and the vacuum pump is configured to restore the air pressure in the first chamber to a preset air pressure value.

In the embodiments of the present application, when the first pressure sensor detects an abnormal air pressure in the first chamber, the solenoid valve and the vacuum pump are switched on to adjust an air pressure in the liquid-cooling system, which may improve reliability of operation of the liquid-cooling system.

In a second aspect, the present application provides a method of controlling the two-phase liquid-cooling system as described in the first aspect. The system includes a control unit and a sensor, and further includes a valve and/or a pump body; the control unit is connected to the sensor, and is further connected to the valve and/or the pump body. The method includes:
acquiring, by the control unit, data collected by the sensor; and controlling, by the control unit, an opening degree of the valve and/or on/off of the pump body based on the data.

In a possible implementation, the system further includes a second chamber, the sensor includes a first pressure sensor, the valve includes a solenoid valve, and the pump body includes a vacuum pump; a flow channel inlet of the second chamber is connected to a first outlet of the condenser, a gas outlet of the second chamber is connected to outside air through the solenoid valve and the vacuum pump, and the first pressure sensor is disposed in the first chamber. The acquiring, by the control unit, the data collected by the sensor, includes: acquiring, by the control unit, first pressure data collected by the first pressure sensor; and the controlling, by the control unit, the opening degree of the valve and/or the on/off of the pump body based on the data, includes: when the first pressure data is greater than a third pressure threshold, or continuously greater than a first pressure threshold within a first preset period, switching on, by the control unit, the solenoid valve and the vacuum pump, to adjust the opening degree of the solenoid valve and control the vacuum pump to extract air in the second chamber; and when the first pressure data is less than a fourth pressure threshold, or continuously less than a second pressure threshold within the first preset period, switching on, by the control unit, the solenoid valve; where, the third pressure threshold is greater than the first pressure threshold, and the fourth pressure threshold is less than the second pressure threshold.

In a possible implementation, the sensor includes a first pressure sensor, and the first pressure sensor is disposed in the first chamber; the valve further includes a first proportional valve in the condenser, the condenser further includes a first cold source and a first heat exchange unit, the first cold source is connected to the first heat exchange unit, a first coolant input from the first cold source exchanges heat with an insulating working medium input from the first chamber in the first heat exchange unit, the first proportional valve is configured to control a flow rate of the first coolant in the first heat exchange unit; the acquiring, by the control unit, the data collected by the sensor, includes: acquiring, by the control unit, the first pressure data collected by the first pressure sensor; and the controlling, by the control unit, the opening degree of the valve and/or the on/off of the pump body based on the data, includes: when the first pressure data is greater than the first pressure threshold, increasing, by the control unit, the opening degree of the first proportional valve; and when the first pressure data is less than the second pressure threshold, decreasing, by the control unit, the opening degree of the first proportional valve.

In a possible implementation, the pump body includes a first pump body, the sensor includes a liquid level sensor disposed in the first chamber, a first end of the first pump body is connected to a liquid outlet of the first chamber, and a second end of the first pump body is connected to a flow channel inlet of each liquid-cooling node, respectively; the acquiring, by the control unit, the data collected by the sensor, includes: acquiring, by the control unit, liquid level data collected by the liquid level sensor; and the controlling, by the control unit, the opening degree of the valve and/or the on/off of the pump body based on the data, includes: switching on or switching off, by the control unit, the first pump body based on the liquid level data.

In a possible implementation, the system further includes a liquid reservoir, the sensor includes a second pressure sensor, the valve includes a bypass valve, and the pump body further includes a second pump body; a first end of the liquid reservoir is connected to a first outlet of the condenser, a second end of the liquid reservoir is connected to a first end of the second pump body, a second end of the second pump body is connected to a flow channel inlet of the liquid-cooling node, a first end of the bypass valve is connected to a second end of the second pump body, a second end of the bypass valve is connected to the first end of the liquid reservoir, and the second pressure sensor is disposed at the second end of the second pump body; the acquiring, by the control unit, the data collected by the sensor, includes: acquiring, by the control unit, second pressure data collected by the second pressure sensor; and the controlling, by the control unit, the opening degree of the valve and/or the on/off of the pump body based on the data, includes: when the second pressure data is greater than a fifth pressure threshold, increasing, by the control unit, the opening degree of the bypass valve; and when the second pressure data is less than a sixth pressure threshold, decreasing, by the control unit, the opening degree of the bypass valve.

In a possible implementation, the system further includes a subcooler, the pump body includes a second pump body, the sensor includes a temperature sensor and a third pressure sensor, the temperature sensor is disposed at a second end of the second pump body, and the third pressure sensor is disposed at a first end of the second pump body; the subcooler includes a second proportional valve, a second heat exchange unit, and a second cold source, a first inlet of the subcooler is connected to a first outlet of the condenser, a first outlet of the subcooler is connected to a first end of the second pump body, a second end of the second pump body is connected to a flow channel inlet of a liquid-cooling node, the second heat exchange unit is connected to the second cold source, a second coolant input from the second cold source exchanges heat with an insulating working medium received from the subcooler in the second heat exchange unit, and the second proportional valve is configured to control a flow rate of the second coolant in the second heat exchange unit; the acquiring, by the control unit, the data collected by the sensor, includes: acquiring, by the control unit, temperature data collected by the temperature sensor, and the third pressure data collected by the third pressure sensor; the controlling, by the control unit, the opening degree of the valve and/or the on/off of the pump body based on the data, includes: when the temperature data is higher than a sum of a saturation temperature corresponding to the third pressure data and a preset temperature threshold, increasing, by the control unit, the opening degree of the second proportional valve; and when the temperature data is lower than a dew point temperature of an equipment room where the system is located, decreasing, by the control unit, the opening degree of the second proportional valve.

It should be understood that the implementations and beneficial effects of the above aspects may be referenced each other.

### BRIEF DESCRIPTION OF DRAWINGS

FIG. 1 is a structural diagram of a first two-phase liquid-cooling system according to an embodiment of the present application;
FIG. 2 is a structural diagram of a second two-phase liquid-cooling system according to an embodiment of the present application;
FIG. 3 is a structural diagram of a third two-phase liquid-cooling system according to an embodiment of the present application;
FIG. 4 is a structural diagram of a fourth two-phase liquid-cooling system according to an embodiment of the present application;
FIG. 5 is a structural diagram of a fifth two-phase liquid-cooling system according to an embodiment of the present application;
FIG. 6 is a structural diagram of a sixth two-phase liquid-cooling system according to an embodiment of the present application; and
FIG. 7 is a flow chart of a method of controlling a two-phase liquid-cooling system according to an embodiment of the present application.

### DESCRIPTION OF EMBODIMENTS

The following describes embodiments of the present application with reference to accompanying drawings. Apparently, the described embodiments are some but not all of the embodiments of the present application. A person of ordinary skill in the art may know that, with the development of technologies and emergence of new scenarios, the technical solutions provided in the embodiments of the present application are also applicable to a similar technical issue.

In the description, claims, and accompanying drawings of the present application, terms such as "first" and "second" are intended to distinguish similar objects, but do not necessarily indicate a specific order or sequence. It should be understood that the data used in this way may be interchanged where appropriate, so that the embodiments described herein can be implemented in an order other than what is illustrated or described. In addition, the terms "include", "have", and any other variants thereof are intended to cover non-exclusive inclusion, so that a process, method, system, product, or device that includes a series of steps or units is not necessarily limited to those steps or units, but may include other units not expressly listed or inherent to such a process, method, system, product, or device.

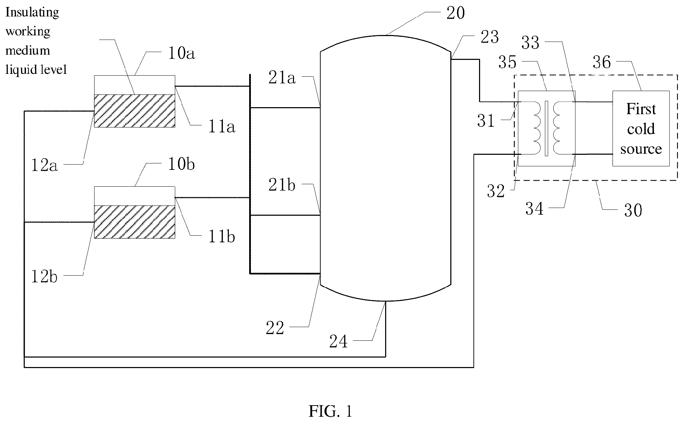

As shown in FIG. 1, FIG. 1 is a structural diagram of a first two-phase liquid-cooling system according to an embodiment of the present application. As shown in FIG. 1, the two-phase liquid-cooling system (hereinafter referred to as a liquid-cooling system) includes liquid-cooling nodes 10a to 10b (hereinafter collectively referred to as liquid-cooling nodes 10), a first chamber 20, and a condenser 30.

The liquid-cooling node 10 is configured to accommodate a heat source component and an insulating working medium. The heat source component is partially or wholly immersed in the insulating working medium. Specifically, the heat source component may be a component of a communication device, a computing device or other devices that need continuous cooling in a working state, such as a server board, a multi-node server, a central processing unit (central processing unit, CPU) or other processing chips on the board, a hard disk of the device, etc. The heat source component continuously generates heat after entering the working state; the insulating working medium has characteristics of a phase transition between a gas phase and a liquid phase.

Each liquid-cooling node 10 is provided with a flow channel outlet 11 and a flow channel inlet 12. The flow channel outlet 11 is configured to discharge an insulating working medium in the liquid-cooling node 10; and the flow channel inlet 12 is configured to replenish a liquid insulating working medium after releasing heat and cooling to the liquid-cooling node 10.

Specifically, the flow channel outlet 11 may be configured to discharge at least one of a gaseous insulating working medium, a liquid insulating working medium or a gas-liquid mixed insulating working medium. During circulation of the insulating working medium, the liquid insulating working medium in the liquid-cooling node 10 absorbs the heat generated by the heat source component and transitions into a gaseous state, and then is discharged from the flow channel outlet 11. It can be understood that the discharged gaseous insulating working medium more or less entrains small droplets of the liquid insulating working medium, meaning that the discharged insulating working medium in this case is in a gas-liquid mixed state. In addition, in a case that a speed at which the liquid working medium is replenished at the flow channel inlet 12 is faster than a speed at which the gas-liquid mixed insulating working medium is discharged from the liquid-cooling node 10, the liquid level of the insulating working medium continuously rises until it is higher than the flow channel outlet 11. In this case, the liquid insulating working medium with the liquid level higher than the flow channel outlet 11 is discharged from the flow channel outlet 11.

The flow channel outlet 11 of each liquid-cooling node 10 is connected to a first inlet 21 of the first chamber 20. In a specific example shown in FIG. 1, a flow channel outlet 11a is connected to a first inlet 21a, and a second flow channel outlet 11b is connected to a first inlet 21b.

It is understandable that there may be a plurality of first inlets 21, which is equivalent to that an overall diameter of the first inlets 21 is increased, which can increase a speed at which the insulating working medium enters the first chamber 20.

It is understandable that in the embodiment of the present application, connection relationships for fluid conveyance refer to connections through pipelines. Straight lines connecting components in diagrams represent pipelines through which fluids in the components may be conveyed. Specifically, the pipelines refer to rigid pipelines or flexible pipelines, which are not limited here.

It is understandable that, due to the physical property that the gaseous insulating working medium has a lower density than the liquid insulating working medium, in the liquid-cooling system, an inlet and an outlet for conveying gas in a same component may be higher than an inlet and an outlet for conveying a liquid. This allow for natural fluid flow and gas-liquid separation in the liquid-cooling system without the need for additional energy consumption to perform work. The embodiment of the present application is described by taking the gas inlet and the gas outlet in the same component being higher than the liquid inlet and the liquid outlet and the liquid inlet being higher than the liquid outlet for example. For example, for the first chamber 20 in the embodiment, the first inlet 21 for entering gas may be higher than the second inlet 22 for entering liquid, and a gas outlet 23 for discharging gas may be higher than a liquid outlet 24 for discharging liquid; further, the gas outlet 23 may be higher than the first inlet 21, and the liquid outlet 24 may be lower than the second inlet 22. The second chamber 40 in the following embodiments is similarly applied.

Optionally, density of the insulating working medium in the gaseous state is less than the density of air.

In this case, the air in the liquid-cooling system does not affect flow of the insulating working medium and gas-liquid separation. For example, in a case that the air exists in the first chamber 20, if the density of the insulating working medium in the gaseous state is greater than that of the air, the insulating working medium sinks after entering the first chamber 20, and is sandwiched between the air and the liquid insulating working medium and difficult to flow to the gas outlet 23 located near the top of the first chamber, thus affecting the effect of gas-liquid separation, thereby limiting a height setting of the gas outlet 23; conversely, if the density of the insulating working medium in the gaseous state is less than that of the air, the air in the first chamber 20 does not affect flow and gas-liquid separation of the insulating working medium.

In some other embodiments, the density of the insulating working medium in the gaseous state may also be greater than or equal to the density of air. In this case, the air content in the liquid-cooling system may be minimized as much as possible to reduce the influence of the air on the flow of the insulating working medium and the gas-liquid separation.

For ease of understanding, the embodiment of the present application is described by taking the density of the insulating working medium in the gaseous state being less than the density of air for example.

It is understandable that in the embodiment of the present application, a single component or a plural quantity of components labeled as a, b are examples rather than a limitation, and a specific quantity may be determined according to actual needs.

The first chamber 20 is configured to collect an insulating working medium discharged from a plurality of liquid-cooling nodes 10 and naturally separate the gaseous insulating working medium from the liquid insulating working medium based on different physical properties of the insulating working medium in the gaseous and liquid states; at the same time, the first chamber 20 is further configured to separate the liquid-cooling nodes 10 from the condenser 30, to prevent the condensed insulating working medium from directly flowing back and liquid-sealing the liquid-cooling nodes 10, which results in excessive internal pressures in the liquid-cooling nodes 10.

Since the density of the gaseous insulating working medium is less than that of the liquid insulating working medium, after the insulating working medium enters the first chamber 20, the liquid insulating working medium sinks to the bottom of the first chamber 20 under the action of gravity; the gaseous insulating working medium rises to the top of the first chamber 20 under the action of buoyancy.

In the embodiment, after initial gas-liquid separation on the insulating working medium in the first chamber 20 is completed, the gaseous insulating working medium enters the condenser 30 through the gas outlet 23 disposed at the top of the first chamber 20 for further heat dissipation and cooling; the liquid insulating working medium flows back to the liquid-cooling node 10 through the liquid outlet 24 disposed at the bottom of the first chamber 20.

Optionally, the first chamber 20 is further provided with a second inlet 22 lower than the first inlet 21, and the second inlet 22 is connected to the flow channel outlet 11 of each liquid-cooling node 10. In a specific example of FIG. 1, both the flow channel outlets 11a and 11b are connected to the second inlet 22a.

The gaseous insulating working medium discharged from the liquid-cooling node 10 may flow into the first chamber 20 through the first inlet 21 under the action of buoyancy, and the liquid insulating working medium discharged may flow into the first chamber 20 through the second inlet 22 under the action of gravity. By disposing the second inlet 22 lower than the first inlet 21, gas-liquid separation may be achieved on the insulating working medium discharged from the liquid-cooling node 10.

Optionally, the flow channel outlet 11 of each liquid-cooling node 10 is higher than the second inlet 22.

In this case, the liquid insulating working medium discharged from the liquid-cooling node 10 may flow into the first chamber 20 through the second inlet 22 under the action of gravity; at the same time, when the liquid level of the first chamber 20 is higher than the second inlet 22 and lower than the flow channel outlet 11, the liquid-cooling node 10 can still discharge the liquid insulating working medium from the first chamber 20, further avoiding that the flow channel outlet 11 is blocked.

Specifically, the first chamber 20 may be a static pressure chamber, and is configured to transform internal gas flow inside the first chamber 20 into static pressure flow, making gas flow at the gas outlet more uniform, with less resistance, and facilitating to convey the gaseous insulating working medium.

The gas outlet 23 of the first chamber 20 is connected to a first inlet 31 of the condenser 30, and the liquid outlet 24 of the first chamber 20 is connected to the flow channel inlet 12 of the liquid-cooling node 10; a first outlet 32 of the condenser 30 is connected to the flow channel inlet 12 of the liquid-cooling node 10.

The condenser 30 is configured to condense a gaseous insulating working medium conveyed by the first chamber 20. The condenser 30 may be a dividing wall type heat exchanger, specifically a plate heat exchanger, a jacketed heat exchanger or an immersion serpentine-tube heat exchanger.

The condenser 30 may include a first heat exchange unit 35 and a first cold source 36. The first cold source 36 is configured to input a first coolant into the first heat exchange unit 35, where the first coolant exchanges heat with the insulating working medium input from the first chamber 20 into the condenser 30 in the first heat exchange unit 35. The heat of the gaseous insulating working medium is absorbed by the first coolant, causing the gaseous insulating working medium to transition to a liquid insulating working medium.

Specifically, the first inlet 31 and the second inlet 32 of the condenser 30 are also a first inlet 31 and a first outlet 32 of the first heat exchange unit 35; the second inlet 34 and the second outlet 33 of the first heat exchange unit 35 are connected to the first cold source 36.

The cold source may be a natural cold source, such as a cooling tower located outdoors in winter; or an artificial cold source, such as a mechanical refrigeration apparatus.

Optionally, the height of the gas outlet 23 is higher than the height of the first inlet 31 of the condenser.

The gas outlet 23 is disposed to be higher than the first inlet 31 of the condenser, which may prevent backflow of a liquid insulating working medium cooled and liquefied at the first inlet 31 of the condenser or a liquid insulating working medium entrained in the gaseous insulating working medium, reducing resistance for the gaseous insulating working medium in the first chamber 20 to enter the condenser 30.

Optionally, the flow channel outlet 11 of the liquid-cooling node 10 is connected to the first inlet 21 and the second inlet 22 of the first chamber 20 through a multi-branch pipeline, and a quantity of the first inlets 21 of the first chamber 20 corresponds to a quantity of the liquid-cooling nodes 10.

In the embodiment, the multi-branch pipeline is disposed to connect the liquid-cooling nodes 10 and the first chamber 20, which is equivalent to that all the liquid-cooling nodes 10 share all the first inlets 21 and the second inlets 22 connected by the multi-branch pipeline. In this way, when heat source components of some of the liquid-cooling nodes 10 in the liquid-cooling system run at a full load, pressure of the gaseous insulating working medium on the pipeline may be distributed. In addition, there is no need to provide two pipelines for each flow channel outlet 11 to connect the first inlet 21 and the second inlet 22 respectively, which may simplify the pipelines of the liquid-cooling system and save cost.

In a possible implementation, the liquid-cooling node 10 is disposed inside a cabinet, and a multi-branch pipeline connecting the liquid-cooling nodes 10 is suspended and disposed outside the cabinet. The implementation may save space inside the cabinet.

The working principle of the liquid-cooling system is as follows.

The heat source component in the liquid-cooling node 10 generates heat after entering the working state. The insulating working medium absorbs the heat from the heat source component and transitions to a gaseous insulating working medium to rise, and the gaseous insulating working medium flows through the flow channel outlet 11 and the first inlet 21 into the first chamber 20, and then through the gas outlet 23 into the condenser 30. The gaseous insulating working medium releases heat in the condenser 30 and transitions to a liquid insulating working medium, and then is returned to the liquid-cooling node 10 through the first outlet 32 and the flow channel inlet 12.

During the working of the above liquid-cooling system, the insulating working medium in the liquid-cooling node 10 expands as it absorbs heat before vaporization, resulting in a larger volume. When the liquid level of the insulating working medium in the liquid-cooling node 10 is higher than the flow channel outlet 11 due to fluctuation caused by the volume change, the liquid insulating working medium higher than the flow channel outlet 11 enters the first chamber 20 through the second inlet 22 under the action of gravity. The gaseous insulating working medium may be cooled and transition to a liquid insulating working medium before entering the condenser 30. The gaseous insulating working medium may entrain some liquid insulating working medium.

In the above three cases, the first chamber 20 contains both the gaseous insulating working medium and the liquid insulating working medium. The first chamber 20 may perform gas-liquid separation on the insulating working medium in the first chamber through the gas outlet 23 and the liquid outlet 24; specifically, the gaseous insulating working medium may enter the condenser 30 through the gas outlet 23, and the liquid insulating working medium may flow back to the liquid-cooling node 10 through the liquid outlet 24.

Through gas-liquid separation, the proportion of the gaseous insulating working medium in the fluid entering the condenser 30 can be increased, thus releasing more heat during a liquefaction process and enhancing the heat dissipation effect of the liquid-cooling system. At the same time, the first chamber 20 may serve as a buffer to prevent the liquid insulating working medium in any of the above three cases from blocking the flow channel outlet 11 due to backflow.

The liquid insulating working medium separated from the first chamber 20 may be returned to the liquid-cooling node 10 through the liquid outlet 24, which prevents the second inlet 22 from being blocked by the liquid insulating working medium, thus further preventing the flow channel outlet 11 in the liquid-cooling node 10 from being blocked.

In the embodiment of the present application, the first chamber 20 is disposed between the liquid-cooling node 10 and the condenser 30 for gas-liquid separation and backflow blockage, which not only may save economic and energy costs required for deployment and operation of a gas-liquid separator, but also may avoid that the flow channel outlet 11 is blocked, solving a layout limitation problem of the flow channel outlet 11 on the liquid-cooling node 10, thereby making the layout of the liquid-cooling node 10 more flexible.

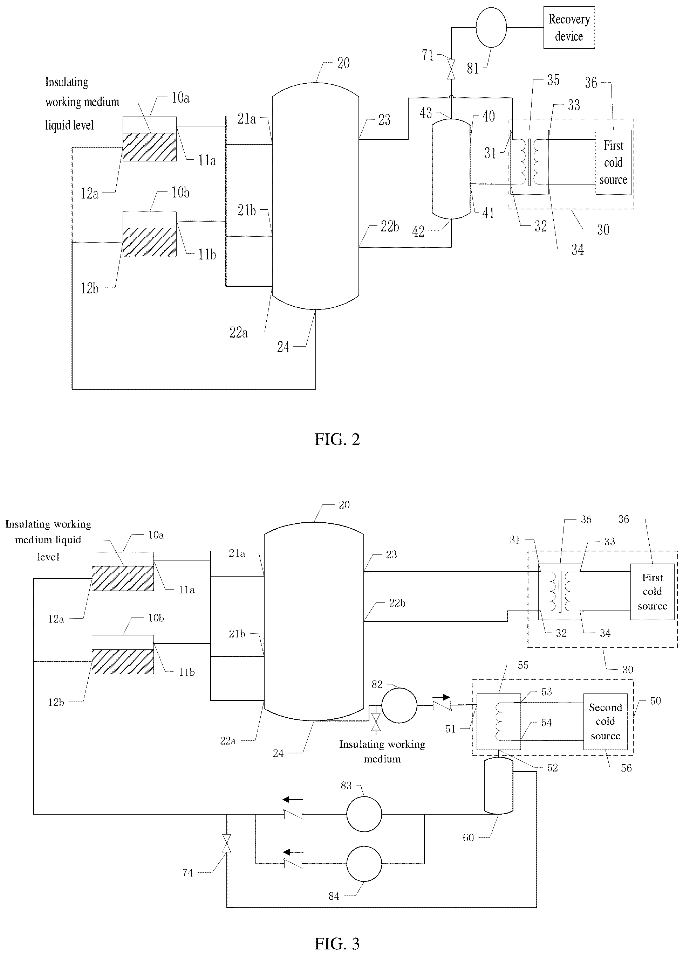

The above is a basic architecture of the liquid-cooling system provided in the embodiment of the present application. The liquid-cooling system provided in the embodiment of the present application will be described in more detail in combination with embodiments shown in FIGS. 2 to 4.

As shown in FIG. 2, FIG. 2 is a structural diagram of a second two-phase liquid-cooling system according to an embodiment of the present application.

In this case, the functions, effects and working principles of the liquid-cooling node 10, the first chamber 20 and the condenser 30 in the liquid-cooling system shown in FIG. 2 are similar to those of corresponding components in the specific example of FIG. 1. For details, refer to relevant descriptions of the embodiment part of FIG. 1, which will not be repeated here.

The liquid-cooling system further includes a second chamber 40, and the second chamber 40 is configured to separate liquid and gas output from the condenser 30. In the embodiment, the first outlet 32 of the condenser 30 is connected to a flow channel inlet 41 of the second chamber 40, a gas outlet 43 of the second chamber 40 leads to outside air, and a liquid outlet 42 of the second chamber 40 may be connected to the second inlet 22 of the first chamber, or may be connected to the flow channel inlet 12 of the liquid-cooling node 10. In a specific example of FIG. 2, the liquid outlet 42 of the second chamber 40 may be connected to a second inlet 22b of the first chamber.

The liquid insulating working medium output from the first outlet 32 of the condenser 30 is returned to the liquid-cooling node 10 through the second chamber 40.

It is understandable that when gas received at the first inlet 31 of the condenser 30 is mixed gas of the gaseous insulating working medium and air, the condenser 30 may liquefy the insulating working medium in the mixed gas using low-temperature cooling water or coolant, while the air portion remains in a gaseous state, and then the liquid insulating working medium and the air are input into the second chamber 40. Similar to the first chamber 20, the liquid insulating working medium flows to the liquid outlet 42 under the action of gravity and flows through the second inlet 22b into the first chamber 20; the air rises and flows to the outside through the gas outlet 43.

It is understandable that the air may dissolve in the liquid insulating working medium, and when reaching saturation, the air exists in the liquid insulating working medium in the form of bubbles; these bubbles may interfere with liquid cooling circulation and affect the heat dissipation performance. When a pump is configured in the liquid-cooling system, these bubbles may further interfere with rotation of an impeller, and even damage bearings of the pump. Therefore, it is necessary to reduce the air content in the liquid insulating working medium, and air mixed with the liquid insulating working medium may be separated through the second chamber 40.

Optionally, the gas outlet 43 is a switchable gas port, and is configured to be switched on when an internal air pressure of the liquid-cooling system is excessively high or excessively low.

Optionally, the liquid-cooling system further includes a solenoid valve 71 and a vacuum pump 81. The gas outlet 43 is connected to a first end of the vacuum pump 81 by the solenoid valve 71, and a second end of the vacuum pump 82 is connected to the outside air.

When the internal air pressure of the liquid-cooling system is excessively high or excessively low, the solenoid valve 71 and the vacuum pump 81 may be switched on, so that the internal air pressure of the liquid-cooling system is restored to a preset air pressure level. Specifically, when the internal air pressure of the liquid-cooling system is excessively high, the solenoid valve 71 and the vacuum pump 81 may be switched on to control the vacuum pump 81 to extract air in the second chamber 40, quickly reducing the internal air pressure to the preset air pressure level; when the internal air pressure of the liquid-cooling system is excessively low, the solenoid valve 71 may be switched on to allow the outside air to enter the liquid-cooling system.

It is understandable that a switch of the solenoid valve 71 is interlocked with a switch of the vacuum pump 81. When the vacuum pump 81 is switched off, the solenoid valve 71 is automatically switched off to prevent the outside air from entering to a maximum extent.

Optionally, a second end of the vacuum pump 81 is connected to a recovery device, and the recovery device is configured to recover the insulating working medium from air discharged from the liquid-cooling system, so as to reduce environmental pollution caused by the insulating working medium.

In the embodiment of the present application, the second chamber 40 is disposed to perform another gas-liquid separation on the fluid output from the condenser 30, which may reduce the air content of the liquid insulating working medium in the liquid-cooling system; a discharge port of the liquid-cooling system is disposed in the second chamber 40, compared with the solution that the discharge port is directly disposed in the chamber where the mixed gas of the air and the gaseous insulating working medium is located, which reduces the content of the insulating working medium in the gas discharged from the liquid-cooling system, thereby reducing environmental pollution caused by the insulating working medium and protecting environment.

As shown in FIG. 3, FIG. 3 is a structural diagram of a third two-phase liquid-cooling system according to an embodiment of the present application.

The functions, effects and working principles of the liquid-cooling node 10, the first chamber 20 and the condenser 30 in the liquid-cooling system shown in FIG. 3 are similar to those of corresponding components in the specific example of FIG. 1. For details, refer to relevant descriptions of the embodiment part of FIG. 1, which will not be repeated here.

In a possible implementation, the liquid-cooling system further includes a first pump body 82, where a first end of the first pump body 82 is connected to the liquid outlet 24 of the first chamber 20, and a second end of the first pump body 82 is connected to the flow channel inlet 12 of each liquid cooling node 10.

The first pump body 82 is configured to quickly reduce a liquid level height in the first chamber 20 to prevent the second inlet 22 from being liquid-sealed. Specifically, the first pump body 82 is configured to pump the liquid insulating working medium in the first chamber 20 to a component connected to the second end of the first pump body 82. For example, when the second end of the first pump body 82 is directly connected to the flow channel inlet 11 of the liquid-cooling node 10, the first pump body 82 is configured to pump the liquid insulating working medium in the first chamber 20 to the liquid-cooling node 10.

In another possible implementation, the liquid-cooling system further includes a first pump body 82, where a first end of the first pump body 82 is connected to an insulating working medium source, and a second end is connected to the flow channel inlet 12.

The first pump body 82 is configured to replenish the insulating working medium to the liquid-cooling system.

In another possible implementation, the liquid-cooling system further includes a first pump body 82, a first end of the first pump body 82 is connected to the liquid outlet 24 of the first chamber 20, and respectively connected to the liquid outlet 24 of the first chamber 20 and the insulating working medium source, and a second end is connected to the flow channel inlet 12.

Optionally, the liquid-cooling system further includes a subcooler 50. A first inlet 51 of the subcooler 50 may be connected to the liquid outlet 24 of the first chamber 20, and the first outlet 52 is connected to the flow channel inlet 12 of the liquid-cooling node 10.

The subcooler 50 may be a plate heat exchanger, and specifically may be a plate heat exchanger, a jacketed heat exchanger or an immersion serpentine-tube heat exchanger. In a specific example of FIG. 3, the subcooler 50 is an immersion serpentine-tube heat exchanger. The subcooler 50 is configured to further cool the liquid insulating working medium, so that the liquid insulating working medium may absorb more heat after being conveyed to the liquid-cooling node 10.

The condenser 50 may include a second heat exchange unit 55 and a second cold source 56. The second cold source 56 is configured to input a second coolant into the second heat exchange unit 55; the liquid insulating working medium collected in the first chamber 20 flows through the liquid outlet 24 and the first inlet 51 into the subcooler 50. After the liquid insulating working medium exchanges heat with the second coolant in the second heat exchange unit 55 and is cooled, and the cooled liquid insulating working medium returns to the liquid-cooling node 10.

Specifically, the first inlet 51 and the second inlet 52 of the subcooler 50 are also a first inlet 51 and a first outlet 52 of the second heat exchange unit 55; a second inlet 54 and a second outlet 53 of the first heat exchange unit 55 are connected to the second cold source 56.

Optionally, as shown in the specific example of FIG. 3, a second end of the first pump body 82 may be connected to the flow channel inlet 12 by the subcooler 50, a first end of the first pump body 82 is connected to the liquid outlet 24, and a second end is connected to the first inlet 51, and is configured to pump the liquid insulating working medium in the first chamber 20 to the subcooler 50, to convey the liquid insulating working substance to the liquid-cooling node 10 by the subcooler 50.

Optionally, the first end of the first pump body 82 is further connected to the insulating working medium source, and the second end is connected to the first inlet 51; and the liquid outlet 24 of the first chamber 20 is higher than the first inlet 51 of the subcooler 50.

The liquid insulating working medium in the first chamber 20 may flow into the subcooler 50 under the action of gravity, and the first pump body 82 is configured to pump the insulating working medium in the insulating working medium source to the subcooler 50.

Optionally, a check valve is further disposed at the second end of the first pump body 82, preventing the liquid insulating working medium from backflow.

By configuration that the condenser 30 and the subcooler 50 in the liquid-cooling system take on responsibilities of condensation and cooling respectively, a vaporized insulating working medium may be first recovered from the mixed gas through the condenser 30, while air in the mixed gas may be separated. Then, an insulating working medium with higher purity is cooled by the subcooler 50, which can maximize a heat absorption capacity of the insulating working medium while reducing the mixed water or other conductive components in the air, maintaining purity of the insulating working medium, thereby improving the safety and heat dissipation efficiency of the liquid-cooling system.

Optionally, the liquid-cooling system further includes a second pump body 83, a first end of the second pump body 83 is connected to the first outlet 52 of the subcooler 50, and a second end of the second pump body 83 is connected to the flow channel inlet 12 of the liquid-cooling node 10; and the second pump body 83 is configured to pump the insulating working medium in the subcooler 50 to the liquid-cooling node 10.

Optionally, a liquid reservoir 60 is further disposed between the subcooler 50 and the second pump body 83, and the liquid reservoir 60 is configured to store the liquid insulating working medium; a first end of the liquid reservoir 60 is connected to the first outlet 52 of the subcooler 50, and a second end is connected to a second end of the second pump body 83, that is, as shown in the specific example of FIG. 3, the first outlet 52 of the subcooler 50 is connected to the flow channel inlet 12 of the liquid-cooling node 10 by the liquid reservoir 60 and the second pump body 83.

The second pump body 83 is configured to pump the insulating working medium in the liquid reservoir 60 to the liquid-cooling node 10.

Optionally, a liquid level sensor may be disposed in the liquid reservoir 60 to estimate an amount of the insulating working medium in the liquid-cooling system based on a liquid level in the current liquid reservoir 60.

Optionally, a third pump body 84 may be disposed between the second end of the liquid reservoir 60 and the flow channel inlet 12, and a first end of the third pump body 84 is connected to the second end of the liquid reservoir and a second end of the third pump body 84 is connected to the flow channel inlet 12; the third pump body 84 serves as a backup pump body of the second pump body 83 and may also be configured to pump the liquid insulating working medium in the liquid reservoir 60 to the liquid-cooling node 10.

The third pump body 84 may be switched on simultaneously with the second pump body 83, or may be switched on when the second pump body 83 is faulty.

The second pump body 83 may be switched on when the heat source device enters an working state and switched off when the heat source device exits the working state.

It is understandable that a check valve may be provided between the second end of the second pump body 83 and the flow channel inlet 12, preventing the insulating working medium from backflow. The third pump body 84 is similarly applied.

Optionally, the liquid-cooling system further includes a bypass valve 74, a first end of the bypass valve 74 is connected to a second end of the second pump body 83 and/or the third pump body 84, and a second end of the bypass valve 74 is connected to a first end of the liquid reservoir 60; the bypass valve 74 is configured to return some liquid insulating working medium pumped by the second pump body 83 and/or the third pump body 84 to the liquid reservoir 60 when there is sufficient liquid insulating working medium in the liquid-cooling node 10.

By configuration of the bypass valve 74, overflow of the liquid insulating working medium in the liquid-cooling node 10 due to an excessively fast replenishment speed and affecting the heat dissipation effect can be prevented.

By configuration that the liquid reservoir 60 collects the liquid insulating working medium cooled by the subcooler 50 and then conveys the cooled liquid insulating working medium to the liquid-cooling node 10 through the pump body, on one hand, a total amount of the insulating working medium in the liquid-cooling system can be increased, on the other hand, the temperature of the input fluid of the second pump body 83 and/or the third pump body 84 can be more balanced and the inlet pressure more stable.

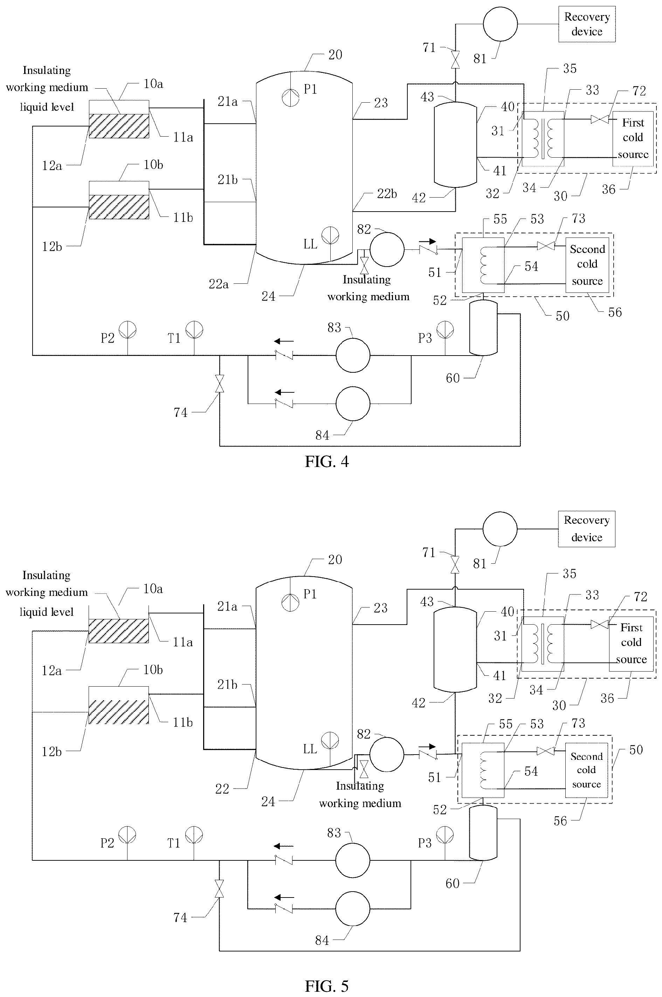

As shown in FIG. 4, FIG. 4 is a structural diagram of a fourth two-phase liquid-cooling system according to an embodiment of the present application. As shown in FIG. 4, the liquid-cooling system may be considered as a combination of the liquid-cooling systems shown in FIGS. 2 and 3. The liquid-cooling system includes a liquid-cooling node 10, a first chamber 20, a condenser 30, a second chamber 40, a subcooler 50 and a liquid reservoir 60.

The functions, effects and working principles of the same components shown in FIG. 4 are similar to those of the same components in the specific example of FIGS. 2 and 3. For details, refer to relevant descriptions of the embodiment parts of FIGS. 2 and 3, which are not be repeated here.

In a possible implementation, the liquid-cooling system further includes a control unit (not shown in the figure) and a sensor, as well as a valve and/or a pump body; the control unit is connected to the sensor, and further connected to the valve and/or the pump body; the control unit is configured to control an opening degree of the valve and on/off of the pump body based on data collected by the sensor.

The liquid-cooling system may include sensors in each pipeline and each component, specifically a sensor for detecting parameters such as temperature, flow rate and pressure of the fluid in the pipeline, as well as a sensor for detecting parameters such as an air pressure and a liquid level in a chamber of the component.

The control unit may be disposed in the liquid-cooling system, and specifically may be a heat source component accommodated in a certain liquid-cooling node of the liquid-cooling system; or may be disposed outside the liquid-cooling system. For example, when liquid-cooling system is disposed in an equipment room, the control unit may be a control system of the equipment room.

The liquid-cooling system may include a valve disposed in each pipeline. The valve has an adjustable opening degree.

By disposing the control unit in the liquid-cooling system, the opening degree of the valve and the on/off of the pump body may be controlled based on data collected by the sensor and a preset control condition, enhancing the intelligence degree of the liquid-cooling system.

In a possible implementation, the sensor includes a first pressure sensor P1 disposed in the first chamber 20; the condenser 30 further includes a first proportional valve 72, and the first proportional valve 72 may be disposed at a second outlet 33 or a second inlet 34 of the first heat exchange unit 35; and the control unit is specifically configured to control an opening degree of the first proportional valve 72 based on the first pressure data. In a specific example of FIG. 4, the first proportional valve 72 is disposed at the second outlet 33 of the first heat exchange unit 35.

The first proportional valve 72 is configured to control a flow rate of the first coolant in the first heat exchange unit 35.

The first pressure data is configured to reflect an air pressure in the first chamber 20. Specifically, when the air pressure in the chamber is greater than a first pressure threshold, the control unit may increase the opening degree of the first proportional valve 72, so as to increase a unit flow rate of the first coolant in the first heat exchange unit 35, that is, to increase a cooling capacity output of the first cold source 36. This causes air in the condenser 30, the second chamber 40 and the first chamber 20 through which the liquid insulating working medium flows to contract with coldness, thereby reducing the air pressure in the liquid-cooling system until the air pressure in the chamber drops to a preset value. When the air pressure in the chamber is less than a second pressure threshold, the control unit may decrease the opening degree of the first proportional valve 72 to reduce the flow rate of the first coolant in the first heat exchange unit 35, that is, to decrease the cooling capacity output of the first cold source 36. This reduces a liquefaction rate of the insulating working medium in the condenser 30, the second chamber 40, and the first chamber 20, thereby increasing the air pressure in the liquid-cooling system until the air pressure in the chamber rises to a preset value.

It is understandable that, since it is necessary to ensure a condensation effect of the condenser 30, causing the condenser 30 to condense the insulating working medium without condensing the air, there is a preset limit to adjustment of the opening degree of the first proportional valve 72. When the first proportional valve 72 is adjusted to its preset limit but fails to solve the air pressure problem, the air pressure in the liquid-cooling system needs to be further adjusted through the gas outlet 43 of the second chamber 40.

In a possible implementation, the control unit is specifically configured to control the solenoid valve 71 and the vacuum pump 81 based on first pressure data in the first chamber 20 collected by the first pressure sensor P1.

The opening degree of the solenoid valve 71 is configured to control a flow rate of air extraction or delivery.

Specifically, when the air pressure in the chamber is greater than a third pressure threshold, or remains greater than the first pressure threshold within the first preset period, the control unit may switch on the solenoid valve 71 and the vacuum pump 81, to adjust the opening degree of the solenoid valve 71 and control the vacuum pump 81 to extract air from the second chamber 40 to rapidly reduce the air pressure in the liquid-cooling system until the air pressure in the chamber drops to a preset value. When the air pressure in the chamber is less than a fourth pressure threshold, or remains less than the second pressure threshold within the first preset period, the control unit may switch on the solenoid valve 71, to adjust the opening degree of the solenoid valve 71 to input the outside air into the second chamber 40, so as to rapidly restore the air pressure in the liquid-cooling system, until the air pressure in the chamber drops to the preset value.

The third pressure threshold is greater than the first pressure threshold, and the fourth pressure threshold is less than the second pressure threshold.

It can be understood that, after the air in the second chamber 40 is input into the first chamber 20 along with the liquid insulating working medium due to input of the outside air, the outside air rises and then recirculates into the second chamber 40. Since the temperature of the liquid insulating working medium flowing through the second chamber 40 is higher than a liquefaction temperature of moisture in the air, purity of the liquid insulating working medium finally input into the subcooler 50 will not be reduced due to input of the outside air.

When the first pressure sensor P1 detects an abnormal air pressure in the first chamber 20, the solenoid valve 71 and the vacuum pump 81 are switched on to adjust the air pressure in the liquid-cooling system, which may improve reliability of operation of the liquid-cooling system.

In a possible implementation, the first pump body 82 is connected to the liquid outlet 24 and the flow channel inlet 12; the sensor further includes a liquid level sensor LL disposed in the first chamber 20; the control unit is specifically configured to control the on and off of the first pump body 82 based on the liquid level data in the first chamber collected by the liquid level sensor LL.

The liquid level data is configured to reflect a liquid level of the liquid insulating working medium in the first chamber 20.

Optionally, when the liquid level is higher than a first liquid level threshold, the control unit may switch on the first pump body 82 for a second preset period.

The liquid level threshold may be determined based on the second inlet 22 of the first chamber 20, and more specifically, determined based on the second inlet 22a directly connected to the liquid-cooling node 10, so that after the second inlet 22a is liquid-sealed, the liquid insulating working medium in the first chamber 20 may be pumped out within shortest time, thereby preventing the flow channel outlet 11 from being blocked due to accumulation of the liquid in a pipeline connected between the flow channel outlet 11 and the second inlet 22a, which could result in an excessive pressure in the liquid-cooling node 10. In some other embodiments, the liquid level threshold may also be set based on a height of the flow channel outlet 11 in the liquid-cooling node 10.

The second preset period may be determined based on the liquid level threshold, that is, within the second preset period, the first pump body 82 may reduce a liquid level corresponding to the liquid level threshold to a preset liquid level.

Optionally, when the liquid level is higher than the second liquid level threshold, the control unit may switch on the first pump body 82; when the liquid level is lower than the third liquid level threshold, the control unit may switch off the first pump body 82.

The third liquid level threshold is lower than the second liquid level threshold.

In a case that the liquid level data reflects the current second inlet 22 or the flow channel outlet 11 is liquid-sealed, the control unit switches on the first pump body 82 to quickly pump the liquid insulating working medium in the first chamber 20 to a component connected to the second end of the first pump body 82, so as to rapidly reduce the liquid level and remove liquid sealing, which may avoid an excessive pressure in the liquid-cooling node 10 caused by the liquid-sealing phenomenon, thereby enhancing reliability of the liquid-cooling system.

In a possible implementation, the sensor includes a second pressure sensor P2 disposed at a second end of the second pump body 83, where the second pressure sensor P2 is configured to collect second pressure data of the input fluid of the liquid-cooling node 10; and the control unit is specifically configured to control the opening degree of the bypass valve 74 based on the second pressure data.

The second pressure data is configured to reflect a fluid input pressure of the liquid-cooling node 10. When the fluid input pressure is greater than a fifth pressure threshold, it indicates that the current liquid-cooling node 10 has a smaller replenishment demand for the liquid insulating working medium, and the control unit may increase the opening degree of the bypass valve 74, thereby increasing an amount of a liquid insulating working medium flowing back to the liquid reservoir 60. When the fluid input pressure is less than a sixth pressure threshold, it indicates that the current liquid-cooling node 10 has a greater replenishment demand for the insulating working medium, and the control unit may decrease the opening degree of the bypass valve 74, increasing an amount of a liquid insulating working medium input into the liquid-cooling node 10.

The bypass valve 74 is disposed to adjust the replenishment rate of the liquid insulating working medium in the liquid-cooling node 10, which may avoid unnecessary waste caused due to an excessive insulating working medium in the liquid-cooling node 10.

In a possible implementation, the subcooler 50 further includes a second proportional valve 73, and the second proportional valve 73 may be disposed at the second outlet 53 or the second inlet 54 of the second heat exchange unit 55; the sensor further includes a temperature sensor T1 and a third pressure sensor P3, the temperature sensor T1 is disposed at a second end of the second pump body 83, and the third pressure sensor P3 is disposed at a first end of the second pump body 83; the control unit is configured to control the opening degree of the second proportional valve 74 based on temperature data collected by the temperature sensor T1 and third pressure data collected by the third pressure sensor P3.

In a specific example of FIG. 4, the second proportional valve 73 is disposed at the second outlet 53. The second proportional valve 73 is configured to control a flow rate of the second coolant in the second heat exchange unit 55.

The temperature data is configured to reflect a temperature of an output fluid of the second pump body 83, and the third pressure data is configured to reflect a pressure of an input fluid of the second pump body 83. When the temperature is higher than a sum of a saturation temperature corresponding to the pressure and a preset temperature threshold, it indicates that a subcooling degree of the input fluid of the second pump body 83 is insufficient, and a proportion of gas in the input fluid is excessively large, which may cause instability of working or a reduced service life of the second pump body 83, and an insulating working medium with a lower temperature needs to be inputted. In this case, the control unit may increase the opening degree of the second proportional valve 73, to increase the cooling capacity input of the second cold source 56, further reducing the temperature of the insulating working medium input into the liquid-cooling node 10.

When the temperature is lower than a dew point of the equipment room, it indicates that the temperature of the insulating working medium entering the liquid-cooling node 10 is relatively low, which may result in condensation on the liquid-cooling node 10 or an outer wall of the pipeline, and the temperature of the insulating working medium input needs to be increased. In this case, the control unit may decrease the opening degree of the second proportional valve 73, reduce the cooling capacity input from the second cold source 56, and appropriately increase the temperature of the insulating working medium input into the liquid-cooling node 10.

By configuration that the second proportional valve 73 adjusts the cooling capacity input of the second cold source 56, a temperature of the insulating working medium input into the liquid-cooling node 10 may be timely adjusted, and the heat dissipation effect of the liquid-cooling system may be ensured while the utilization efficiency of the second cold source is maximized.

It can be understood that, based on the working principle of the liquid-cooling system provided in the embodiment of the present application, a liquid-cooling system with a similar effect is obtained by increase on the basis of the embodiment shown in FIG. 1, or decrease on the basis of the embodiment shown in FIG. 4, or components replacement or position change to both, which all fall within the protection scope of the present application. For example, the sensors, valves or pump bodies shown in FIG. 4 are added to the liquid-cooling system as shown in FIGS. 1 to 3 and correspondingly controlled by a control unit; or, for example, some sensors, valves or pump bodies are removed from the liquid-cooling system as shown in FIG. 4.

As shown in FIG. 5, FIG. 5 is a structural diagram of a fifth two-phase liquid-cooling system according to an embodiment of the present application. The liquid-cooling system is similar in structure to the liquid-cooling system shown in FIG. 4, and differs from the liquid-cooling system shown in FIG. 4 in that the liquid outlet 42 of the second chamber 40 is directly connected to the first inlet 51 of the subcooler 50; that is to say, the liquid insulating working medium condensed by the condenser 30 does not enter the first chamber 20, but may directly enter the subcooler 50 for further cooling.

When the liquid outlet 42 of the second chamber 40 is connected to the first inlet 51 by the first chamber 20, the liquid insulating working medium in the second chamber 40 may first enter the first chamber 20 and then be pumped by the first pump body 82 to the subcooler 50. For ease of description, the connection solution may be referred to as solution one. When the liquid outlet 42 of the second chamber 40 is directly connected to the first inlet 51, the liquid insulating working medium in the second chamber 40 may be directly conveyed to the subcooler 50; and the connection solution may be referred to as solution two.

As shown in FIGS. 4 and 5 again, due to a significant pressure drop in the condenser 30 during a condensation process, in the solution one, a pressure loss caused by the pressure drop only affects flow of the liquid insulating working medium from the second chamber 40 to the first chamber 20. After the liquid insulating working medium enters the first chamber 20, the pressure loss is compensated by the first pump body 82, so that a subsequent conveyance process is not affected by the pressure drop; in the solution two, the pressure drop affects a conveyance process of the liquid insulating working medium from the second chamber 40 to the subcooler 50, and then to the liquid reservoir 60, until the pressure is replenished by the second pump body 83.

Therefore, by adopting the solution one, the influence of the pressure drop generated by the condenser 30 on the liquid-cooling system may be reduced, thereby decreasing resistance to fluid flow in the liquid-cooling system.

On the other hand, when the solution one is adopted, the liquid insulating working medium condensed by the condenser 30 and the liquid insulating working medium discharged from the liquid-cooling node 10 in the first chamber 20 converge, increasing the risk that the flow channel outlet 11 and the second inlet 22 of the liquid-cooling node 10 are liquid-sealed. However, when the solution two is adopted, the liquid insulating working medium flows directly from the second chamber 40 to the subcooler 50, which may reduce the risk that the flow channel outlet 11 and the second inlet 22 of the liquid-cooling node 10 are liquid-sealed.

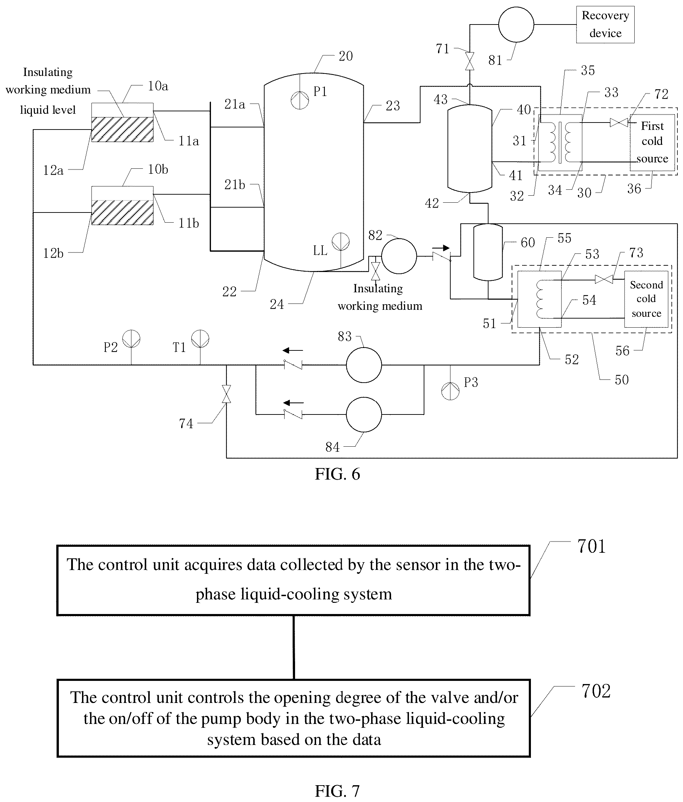

As shown in FIG. 6, FIG. 6 is a structural diagram of a sixth two-phase liquid-cooling system according to an embodiment of the present application. The liquid-cooling system is similar in structure to the liquid-cooling system shown in FIG. 4, and differs from the liquid-cooling system shown in FIG. 4 in that positions of the subcooler 50 and the liquid reservoir 60 are exchanged. The liquid insulating working medium from the second chamber 40 first flows through the liquid reservoir 60, then through the subcooler 50, and is finally pumped by the second pump body 83 to the liquid-cooling node 10.

In this case, the liquid outlet 42 of the second chamber 40 may be connected to the first chamber 20, and connected to a first end of the liquid reservoir 60 by the first chamber 20; or may be directly connected to the first end of the liquid reservoir 60. In a specific example of FIG. 6, the liquid outlet 42 of the second chamber 40 is directly connected to the first end of the liquid reservoir 60.

In other words, the solution where the subcooler 50 exchanges a position with the liquid reservoir 60 may be applied to the liquid-cooling system shown in FIG. 4, as well as the liquid-cooling system shown in FIG. 5.

In the embodiment of the present application, by disposing a position relationship between the subcooler 50 and the liquid reservoir 60, the liquid insulating working medium first passes through the liquid reservoir 60 and then through the subcooler 50, which enables a heat exchange effect after the second proportional valve 73 adjusts the opening degree to be fed back to the liquid-cooling system more quickly, resulting in more timely temperature adjustment.

The above describes the two-phase liquid-cooling system provided in the embodiment of the present application. The following will, based on the above two-phase liquid-cooling system, describe the method of controlling the two-phase liquid-cooling system.

As shown in FIG. 7, FIG. 7 is a flow chart of a method of controlling a two-phase liquid-cooling system according to an embodiment of the present application. The method of controlling the two-phase liquid-cooling system provided in the embodiment of the present application is suitable for the two-phase liquid cooling system shown in any one of the embodiments of FIGS. 1 to 6, and is applicable to the control unit of the liquid-cooling system.

The method includes as follow:
701. Acquire data collected by the sensor in the two-phase liquid-cooling system.

After the liquid-cooling system is switched on, the insulating working medium starts to circulate between various components through the pipeline. As factors such as heat production of the heat source component, components and pipe wear, and outside temperature and air pressure change, parameters in chambers of various components in the liquid-cooling system and parameters inside the pipeline connecting these components change. In this case, corresponding data may be collected through sensors disposed within the chamber and the pipeline, to determine whether the current liquid-cooling system operates normally. In the event of an abnormality, the abnormality problem may be located based on the data, and solved by adopting a corresponding preset solution.

702. Control the opening degree of the valve and/or the on/off of the pump body in the two-phase liquid-cooling system based on the data.

In this case, the valve has an adjustable opening degree.

In the specific implementation, for more operations performed by the control unit in the method of controlling the two-phase liquid-cooling system provided in the embodiment of the present application, refer to relevant parts of the two-phase liquid-cooling system and its working principle as shown in FIGS. 1 to 6, which are not repeated here.

In the embodiment of the present application, by disposing the control unit in the liquid-cooling system, the opening degree of the valve and/or the on/off of the pump body may be controlled based on the data collected by the sensor and a preset control condition. That is, when the data reflects that there is something wrong with the liquid-cooling system, the corresponding opening degree of the valve and/or the on/off of the pump body are controlled to adjust parameters of the liquid-cooling system and restore the parameters to a preset parameter range. This ensures smooth operation of the liquid-cooling system and improves an intelligence degree of the liquid-cooling system.

The above descriptions are only implementations of the present application, but the protection scope of the present application is not limited here. Any changes or substitutions easily conceivable by those skilled in the art within the technical scope disclosed in the present application shall fall within the protection scope of the present application. Therefore, the protection scope of the present application shall be subject to the protection scope of the claims.

## Claims

1. A two-phase liquid-cooling system, wherein the system comprises:
at least one liquid-cooling node, wherein the liquid-cooling node is configured to accommodate a heat source component and an insulating working medium, and the insulating working medium is capable of absorbing heat from the heat source component to be transitioned from a liquid state to a gaseous state; and the liquid-cooling node comprises a flow channel inlet and a flow channel outlet;
a first chamber, wherein the first chamber comprises a first inlet, a gas outlet, and a liquid outlet; and
a condenser, wherein the condenser is configured to liquefy the gaseous insulating working medium into the liquid insulating working medium; and the condenser comprises a first inlet and a first outlet;
the first inlet of the first chamber is connected to the flow channel outlet of each liquid-cooling node, the gas outlet of the first chamber is connected to the first inlet of the condenser, and the first outlet of the condenser and the liquid outlet of the first chamber are respectively connected to the flow channel inlet of each liquid-cooling node; and
the insulating working medium accommodated in the liquid-cooling node, after absorbing heat from the heat source component, is capable of entering the first chamber through the flow channel outlet of the liquid-cooling node and the first inlet of the first chamber; the gaseous insulating working medium in the first chamber is capable of entering the condenser through the gas outlet of the first chamber and the first inlet of the condenser, and after being liquefied by the condenser, entering the liquid-cooling node through the first outlet of the condenser and the flow channel inlet of the liquid-cooling node; and the liquid insulating working medium in the first chamber is capable of entering the liquid-cooling node through the liquid outlet of the first chamber and the flow channel inlet of the liquid-cooling node.

2. The system according to claim 1, wherein the first chamber further comprises a second inlet, the second inlet of the first chamber is lower than the first inlet of the first chamber, and the second inlet of the first chamber is connected to the flow channel outlet of each liquid-cooling node.

3. The system according to claim 2, wherein the flow channel outlet of each liquid-cooling node is higher than the second inlet of the first chamber.

4. The system according to any one of claims 1 to 3, wherein the system further comprises a control unit, a first pump body, and a liquid level sensor disposed in the first chamber, a first end of the first pump body is connected to the liquid outlet of the first chamber, and a second end of the first pump body is connected to the flow channel inlet of each liquid-cooling node, respectively; and
the control unit is configured to control on/off of the first pump body based on liquid level data in the first chamber collected by the liquid level sensor, and the first pump body is configured to pump the liquid insulating working medium in the first chamber to the flow channel inlet of each liquid-cooling node.

5. The system according to any one of claims 1 to 3, wherein the system further comprises a control unit and a first pressure sensor, and the first pressure sensor is disposed in the first chamber; the condenser comprises a first proportional valve, a first heat exchange unit, and a first cold source, the first cold source is connected to the first heat exchange unit, the first cold source is configured to input a first coolant to the first heat exchange unit, the first coolant exchanges heat with the insulating working medium received by the condenser in the first heat exchange unit, and the first proportional valve is configured to control a flow rate of the first coolant in the first heat exchange unit;
the first pressure sensor is configured to collect first pressure data in the first chamber; and
the control unit is configured to control an opening degree of the first proportional valve based on the first pressure data.

6. The system according to any one of claims 1 to 3, wherein the system further comprises a subcooler, a first inlet of the subcooler is connected to the first outlet of the condenser, and a first outlet of the subcooler is connected to the flow channel inlet of the liquid-cooling node; and the subcooler is configured to reduce temperature of the insulating working medium input to the liquid-cooling node.

7. The system according to claim 6, wherein the system further comprises a second pump body, a first end of the second pump body is connected to the first outlet of the subcooler, and a second end of the second pump body is connected to the flow channel inlet of the liquid-cooling node; and
the second pump body is configured to pump the insulating working medium in the subcooler to the liquid-cooling node.

8. The system according to claim 7, wherein the system further comprises a control unit, a temperature sensor, and a third pressure sensor, the temperature sensor is disposed at the second end of the second pump body, and the third pressure sensor is disposed at the first end of the second pump body; the subcooler comprises a second proportional valve, a second heat exchange unit, and a second cold source, the second cold source is connected to the second heat exchange unit, the second cold source is configured to input a second coolant to the second heat exchange unit, the second coolant exchanges heat with the insulating working medium received by the subcooler in the second heat exchange unit, and the second proportional valve is configured to control a flow rate of the second coolant in the second heat exchange unit; and
the control unit is configured to control an opening degree of the second proportional valve based on temperature data collected by the temperature sensor and third pressure data collected by the third pressure sensor.

9. The system according to claim 7, wherein the system further comprises a liquid reservoir, a first end of the liquid reservoir is connected to the first outlet of the subcooler, and a second end of the liquid reservoir is connected to the first end of the second pump body; the liquid reservoir is configured to store the liquid insulating working medium, and the second pump body is configured to pump the insulating working medium in the liquid reservoir to the liquid-cooling node.

10. The system according to claim 9, wherein the system comprises a control unit, a second pressure sensor, and a bypass valve, a first end of the bypass valve is connected to a second end of the second pump body, and a second end of the bypass valve is connected to the first end of the liquid reservoir; the second pressure sensor is disposed at the second end of the second pump body, and the second pressure sensor is configured to collect second pressure data of an output fluid of the second pump body; and
the control unit is configured to control an opening degree of the bypass valve based on the second pressure data.

11. The system according to any one of claims 1 to 3, wherein the system further comprises a second chamber, a flow channel inlet of the second chamber is connected to the first outlet of the condenser, a liquid outlet of the second chamber is connected to the flow channel inlet of the liquid-cooling node, and a gas outlet of the second chamber is connected to outside air.

12. The system according to claim 11, wherein the system further comprises a control unit, a solenoid valve, a vacuum pump, and a first pressure sensor; the gas outlet of the second chamber is connected to the outside air through the solenoid valve and the vacuum pump, and the first pressure sensor is disposed in the first chamber;
the control unit is configured to control an opening degree of the solenoid valve and on/off of the vacuum pump based on first pressure data in the first chamber collected by the first pressure sensor; and
the vacuum pump is configured to restore an air pressure in the first chamber to a preset air pressure value.
